# EUROPEAN PATENT APPLICATION

(11) **EP 2 437 310 A1**
(43) Date of publication of application: **04.04.2012**
(21) Application number: 11731932.7
(22) Date of filing: 06.01.2011
(51) Int. Cl.: H01L 31/042

(54) **SOLAR PHOTOVOLTAIC DEVICE**

(30) Priority: 06.01.2010 KR 20100000995
(71) Applicant: LG Innotek Co., Ltd., Seoul 100-714 (KR)
(72) Inventor: LEE, Seung Yup, Seoul 100-714 (KR)
(74) Representative: Novagraaf Technologies
(86) International application number: PCT/KR2011/000092
(87) International publication number: WO 2011/083994

(57) **Abstract**

Disclosed is a solar cell apparatus. The solar cell apparatus includes a first solar cell; and a second solar cell partially overlapping with the first solar cell and connected to the first solar cell.

## Description

### [Technical Field]

The embodiment relates to a solar cell apparatus.

### [Background Art]

Recently, as energy consumption is increased, a solar cell has been developed to convert solar energy into electrical energy.

In particular, a CIGS-based cell, which is a PN hetero junction apparatus having a substrate structure including a glass substrate, a metallic back electrode layer, a P type CIGS-based light absorbing layer, a high resistance buffer layer, and an N type window layer, has been extensively used.

Especially, the solar cell includes a plurality of cells connected to each other in series and/or in parallel, and the characteristics of a solar cell apparatus may vary depending on the characteristics of the cells.

### [Disclosure]

### [Technical Problem]

The embodiment provides a solar cell apparatus which can be easily manufactured, has improved efficiency, and is flexible.

### [Technical Solution]

According to the embodiment, there is provided a solar cell apparatus including a first solar cell; and a second solar cell partially overlapping with the first solar cell and connected to the first solar cell.

According to the embodiment, there is provided a solar cell apparatus including an insulating substrate, a first solar cell above the insulating substrate, and a second solar cell having a portion interposed between the insulating substrate and the first solar cell while being connected to a bottom surface of the first solar cell.

According to the embodiment, there is provided a solar cell apparatus including a first solar cell, a second solar cell connected to the first solar cell, and a connection member connecting the first solar cell to the second solar cell. The connection member includes conductive polymer.

### [Advantageous Effects]

In the solar cell apparatus according to the embodiment, a plurality of solar cells are connected to each other while being overlapped with each other. Accordingly, the solar cell apparatus according to the embodiment can be formed without a patterning process to distinguish the solar cells from each other and connect the solar cells to each other.

Therefore, the solar cell apparatus according to the embodiment can be easily manufactured.

In addition, in the solar cell apparatus according to the embodiment, the overlap region between the solar cells can be minimized. Further, the overlap region is an active region to convert the sun light into electrical energy.

Accordingly, the solar cell apparatus according to the embodiment has improved power generation efficiency.

In addition, the solar cells and the support substrate including an insulator below the solar cells may be flexible. Therefore, the solar cell apparatus according to the embodiment is flexible.

In particular, when the connection member includes conductive polymer, the connection member can effectively connect the solar cells to each other.

Therefore, the solar cell apparatus according to the embodiment may have improved electrical characteristics.

### [Description of Drawings]

FIG. 1 is a plan view showing a solar cell apparatus according to the embodiment;

FIG. 2 is a sectional view showing a solar cell;

FIG. 3 is a graph showing the composition of group I elements as a function of a height in a light absorbing layer;

FIG. 4 is a sectional view taken along line A-A' of FIG. 1;

FIGS. 5 to 8 are sectional views showing a method of manufacturing solar cells; and

FIGS. 9 and 10 are sectional views showing the manufacturing procedure of forming a light absorbing layer according to another embodiment.

### [Best Mode]

### [Mode for Invention]

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings. The thickness and size of each layer shown in the drawings may be exaggerated, omitted or schematically drawn for the purpose of convenience or clarity. In addition, the size of elements does not utterly reflect an actual size.

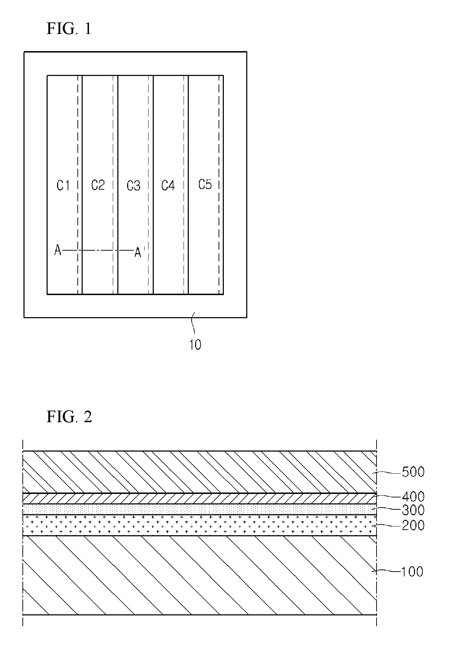

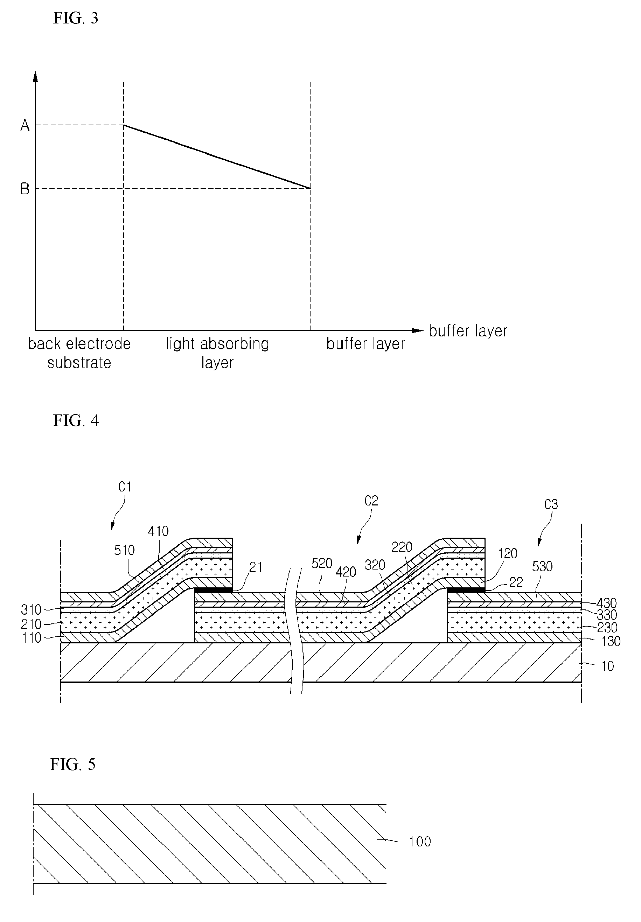

FIG. 1 is a plan view showing a solar cell apparatus according to the embodiment, FIG. 2 is a sectional view showing a solar cell, FIG. 3 is a graph showing the composition of group I elements as a function of a height in a light absorbing layer, and FIG. 4 is a sectional view taken along line A-A' of FIG. 1.

Referring to FIGS. 1 to 4, the solar cell apparatus according to the embodiment includes a support substrate 10, a plurality of solar cells C1, C2, ..., and CN, and a plurality of connection members 21, 22, ..., and N.

The support substrate 10 has a plate shape or a sheet shape. The support substrate 10 supports the solar cells C1, C2, ..., and CN. The support substrate 10 is an insulator. The support substrate 10 may be flexible. In addition, the support substrate 10 may be rigid.

For example, the support substrate 10 may include ethylene vinylacetate (EVA).

The solar cells C1, C2, ..., and CN are provided on the support substrate 10. The solar cells C1, C2, ..., and CN are connected to each other. In more detail, the solar cells C1, C2, ..., and CN may be connected to each other in series. The solar cells C1, C2, ..., and CN may be extended in one direction. In other words, the C1, C2, ..., and CN may be arranged in the form of a stripe.

Each of the solar cells C1, C2, ..., and CN may have a width W1 in the range of about 0.5cm to about 2.5cm. In more detail, each of the solar cells C1, C2, ..., and CN may have the width W1 of about 0.8cm to about 1.2cm.

The solar cells C1, C2, ..., and CN are overlapped with each other. In other words, the solar cells C1, C2, ..., and CN are connected to each other through the overlap region therebetween. In this case, each overlap region between the solar cells C1, C2, ..., and CN may have a width W2 in the range of about 1mm to about 5mm.

The connection members 21, 22, ..., and N connect the solar cells C1, C2, ..., and CN to each other. For example, the connection members 21, 22, ..., and N connect the solar cells C1, C2, ..., and CN, which are overlapped with each other, to each other. In more detail, the connection members 21, 22, ..., and N may be interposed between the solar cells C1, C2, ..., and CN which are overlapped with each other.

Widths of the connection members 21, 22, ..., and N may be equal to the widths W2 of the overlap regions between the solar cells C1, C2, ..., and CN. In addition, the connection members 21, 22, ..., and N may cover the whole bottom surface of the solar cells C1, C2, ..., and CN. Each of the connection members 21, 22, ..., and N has a thickness in the range of about 20µm to about 500µm.

The connection members 21, 22, ..., and N may include conductive polymer. In more detail, the connection members 21, 22, ..., and N may include anthracene conductive polymer, polyaniline conductive polymer, or poly(ethylenedioxythiophene):poly(styrene sulfonate) (PEDOT:PSS)-based conductive polymer.

Therefore, the connection members 21, 22, ..., and N may have high adhesive properties with respect to group I elements and conductive oxide constituting the solar cells C1, C2, ..., and CN. In addition, a material constituting the connection members 21, 22, ..., and N may easily connect the solar cells C1, C2, ..., and CN to each other even in a low-temperature process.

In particular, since the conductive polymer constituting the connection members 21, 22, ..., and N has high corrosion resistance, the solar cells C1, C2, ..., and CN can be prevented from being shorted with each other. The conductive polymer allows the solar cells C1, C2, ..., and CN to easily adhere to each other in a low-temperature process. In addition, since the conductive polymer has elasticity and a lower thermal expansion coefficient, the solar cells C1, C2, ..., and CN can be prevented from being shorted with each other due to the thermal expansion. The conductive polymer can bond the solar cells C1, C2, ..., and CN with each other while representing improved adhesive strength.

As shown in FIG. 2, each of the solar cells C1, C2, ..., and CN includes a back electrode substrate 100, a light absorbing layer 200, a buffer layer 300, a high resistance buffer layer 400, and a window layer 500.

The back electrode substrate 100 has a plate shape, and supports the light absorbing layer 200, the buffer layer 300, the high resistance buffer layer 400, and the window layer 500.

The back electrode substrate 100 is a conductor. In other words, the back electrode substrate 100 is a conductive substrate. The back electrode substrate 100 may be flexible.

The back electrode substrate 100 includes group I elements. In other words, for example, the back electrode substrate 100 may include group I elements such as copper (Cu) or silver (Ag).

In more detail, the back electrode substrate 100 may include group I elements. In detail, the back electrode substrate 100 may include Cu or Ag. In more detail, the back electrode substrate 100 may made of Cu or Ag.

A thickness of the back electrode substrate 100 may be in the range of about 100µm to about 15mm. In detail, the thickness of the back electrode substrate 100 may be in the range of about 300µm to about 5mm.

The light absorbing layer 200 is provided on the back electrode substrate 100. The light absorbing layer 200 includes a group I element. In detail, the light absorbing layer 200 includes the compound of the group I element. In more detail, the light absorbing layer 200 includes a group I-III-VI-based compound. In more detail, the light absorbing layer 200 may be made of a group I-III-VI-based compound.

For example, the group I-III-VI-based compound may include a Cu--based compound selected from the group consisting of a Cu-In-Ga-Se-based compound, a Cu-In-Se-based compound, a Cu-Ga-Se-based compound, a Cu-In-Ga-S-based compound, a Cu-In-S-based compound, a Cu-Ga-S-based compound, and a Cu-In-Ga-Se-S-based compound, or a Cu-III-VI-based compound selected from the group consisting of a Cu-In-Ga-Se-based compound, a Cu-In-Se-based compound, a Cu-Ga-Se-based-compound, a Cu-In-Ga-S-based compound, a Cu-In-S-based compound, a Cu-Ga-S-based compound, and a Cu-In-Ga-Se-S-based compound.

The composition of the group I element constituting the light absorbing layer 200 may vary depending on the position of the light absorbing layer 200. In more detail, the composition of the group I elements constituting the light absorbing layer 200 may be more increased in a direction toward the back electrode substrate 100. In addition, the composition of the group I elements constituting the light absorbing layer 200 may be more reduced in the direction away from the back electrode substrate 100.

In other words, as a height of the light absorbing layer 200 is increased, the light absorbing layer 200 has the lower composition of a group I element. In addition, as the height of the light absorbing layer 200 is reduced, the light absorbing layer 200 has the higher composition of the group I element.

In detail, the light absorbing layer 200 may include a first region adjacent to the back electrode substrate 100, and a second region formed on the first region. The first region includes a group I-III-VI-based compound having the high composition of a group I element, and the second region includes a group I-III-VI-based compound having the composition of the group I element lower than the composition of the group I elements of the first region.

In addition, a group I-III-VI-based compound constituting the lower most surface of the light absorbing layer 200 includes the group I element representing the highest composition. In addition, a group I-III-VI-based compound constituting the upper most surface of the light absorbing layer 200 includes the group I element representing the lowest composition.

For example, the back electrode substrate 100 includes Cu, and the light absorbing layer 200 may include a Cu-III-VI-based compound such as a Cu-In-Ga-Se-based compound, a Cu-In-Se-based compound, a Cu-Ga-Se-based compound, a Cu-In-Ga-S-based compound, a Cu-In-S-based compound, a Cu-Ga-S-based compound, or a Cu-In-Ga-Se-S-based compound. In more detail, the Cu-III-VI-based compound can be represented as following formulas.

Formula 1 : Cu_{X}(In, Ga)_{Y}Se_{2Z}

Formula 2 : Cu_{X}In_{Y}Se_{2Z}

Formula 3 : Cu_{X}Ga_{Y}Se_{2Z}

Formula 4 : Cu_{X}(In, Ga)_{Y}S_{2Z}

Formula 5 : Cu_{X}In_{Y}S_{2Z}

Formula 6 : Cu_{X}Ga_{Y}S_{2Z}

Formula 7 : Cu_{X}(In,Ga)_{Y}(Se,S)_{2Z}

In the above formulas, the X, Y, and Z are greater than 0 and less than 2.

In this case, as shown in FIG. 3, the light absorbing layer 200 includes a Cu-III-VI-based compound having the high X in the direction toward the back electrode substrate 100. In contrast, the light absorbing layer 200 includes a Cu-III-VI-based compound having the low X in the direction away from the back electrode substrate 100.

In other words, the X of the Cu-III-VI-based compound may be gradually lowered in the direction away from the back electrode substrate 100.

For example, a value (A) of the X at the interfacial surface between the back electrode substrate 100 and the light absorbing layer 200 may be in the range of about 0.9 to about 1.5. In addition, a value (B) of the X at the interfacial surface between the light absorbing layer 200 and the buffer layer 300 may be in the range of about 0.5 to about 0.95.

Therefore, the light absorbing layer 200 may include a Cu-III-VI-based compound having the highest Ag composition at the interfacial surface with the back electrode substrate 100. In addition, the light absorbing layer 200 may include a Cu-III-VI-based compound having the lowest Cu composition at the interfacial surface with the buffer layer 300.

The buffer layer 300 is provided on the light absorbing layer 200. The buffer layer 300 includes cadmium sulfide, and the energy band gap of the buffer layer 300 is in the range of about 2.2eV to about 2.4eV.

The high resistance buffer 400 is provided on the buffer layer 300. The buffer layer 400 includes a zinc oxide (i-ZnO) which is not doped with impurities. The energy band gap of the high resistance buffer layer 400 is in the range of about 3.1eV to about 3.3eV.

The window layer 500 is provided on the high resistance buffer layer 400. The window layer 500 is transparent, and includes a conductive layer. The window layer 500 may include a transparent conductive oxide. For example, the material of the window layer 500 may include Al doped ZnO (AZO).

Since the back electrode substrate 100 includes a group I element such as Ag or Cu, the back electrode substrate 100 has low resistance. In particular, the back electrode substrate 100 has lower resistance and represents improved electrical characteristics as compared with an electrode including Mo.

In addition, in the light absorbing layer 200, the composition of the group I element of the group I-III-VI-based compounds may vary with the positions of the light absorbing layer 200, so that the optimal photoelectric transformation efficiency can be represented.

In addition, the light absorbing layer 200 may include a group I-III-VI-based compound having the high composition of the group I element in the direction toward the back electrode substrate 100.

Therefore, the solar cells C1, C2,..., and CN may include the light absorbing layer 200 which represents lower energy band gap toward the back electrode substrate 100. Accordingly, the light absorbing layer 200 can effectively convert the sun light into electrical energy.

In addition, the back electrode substrate 100 may be flexible, and the solar cells C1, C2, ..., and CN may flexible over all.

As shown in FIG. 4, the solar cells C1, C2, ..., and CN are overlapped with each other. In more detail, the solar cells C1, C2, ..., and CN adjacent to each other are partially overlapped with each other. In other words, the solar cells C1, C2, ..., and CN are connected to each other while being overlapped with each other.

For example, a portion of the first solar cell C1 is overlapped with an upper portion of the second solar cell C2. In other words, the upper portion of the second solar cell C2 is interposed between the support substrate 10 and the solar cell C1. In other words, the upper portion of the second solar cell C2 is inserted into the support substrate 10 and the first solar cell C1. In addition, a top surface of the second solar cell C2 is connected to a bottom surface of the first solar cell C1.

In more detail, the first solar cell C1 includes a first back electrode substrate 110, a first light absorbing layer 210, a first buffer layer 310, a first high resistance buffer layer 410, and a first window layer 510 that are sequentially stacked on each other. In addition, the second cell C2 includes a second back electrode substrate 120, a second light absorbing layer 220, a second buffer layer 320, a second high resistance buffer layer 420, and a second window layer 520 which are sequentially stacked on each other.

In this case, a portion of the first back electrode substrate 100 is bent and provided on the second window layer 520. A bottom surface of the first back electrode substrate 110 is connected to a top surface of the second window layer 520.

The first connection member 21 is interposed between the bottom surface of the first back electrode substrate 110 and the top surface of the second window layer 520. The first back electrode substrate 110 is connected to the second window layer 520 through the first connection member 21. In other words, the first connection member 21 directly makes contact with the bottom surface of the firs back electrode substrate 110 and the top surface of the second window layer 520.

As described above, the first connection member 21 may include conductive polymer. In addition, the first connection member 21 may include a conductor, solder paste, or a conductive tape.

In addition, the first connection member 21 may be formed through the following processes.

In order to form the first connection member 21, conductive polymer is coated on the bottom surface of the first back electrode substrate 110 and/or the second window layer 520. In more detail, the conductive polymer may be coated corresponding to the overlap region between the first and second solar cells C1 and C2.

Thereafter, the first and second solar cells C1 and C2 may be overlapped with each other, and may be bonded with each other through thermal compression. Therefore, the first connection member 21 including conductive polymer may be formed between the first and second solar cells C1 and C2.

As described above, since the first connection member 21 includes conductive polymer, the first connection member 21 may be easily formed through a simple process such as a coating scheme or a thermal compression scheme.

Since the first connection member 21 includes conductive polymer, the first connection member 21 may be effectively bonded to the first back electrode substrate 110 and the second window layer 520.

Therefore, the first connection member 21 is effectively bonded to the first back electrode substrate 110 and the second window layer 520, so that the first and second solar cells C1 and C2 are effectively connected to each other physically and electrically.

In addition, the bottom surface of the first back electrode substrate 110 can be connected to the top surface of the second window layer 520 through the direct contact with the top surface of the second window layer 520.

In addition, a portion of the second solar cell C2 is overlapped with the third solar cell C3. In other words, a portion of the third solar cell C3 is interposed between the support substrate 10 and the second solar cell C2. In other words, a portion of the third solar cell C3 is inserted between the support substrate 10 and the second solar cell C2. In addition, the top surface of the third solar cell C3 is connected to the bottom surface of the second solar cell C2.

In detail, the third solar cell C3 includes a third back electrode substrate 130, a third light absorbing layer 230, a third buffer layer 330, a third high resistance buffer layer 430, and a third window layer 530 that are sequentially stacked on each other.

In this case, the portion of the second back electrode substrate 120 is bended and provided on the third window layer 530. A bottom surface of the second back electrode substrate 120 is connected to the top surface of the third window layer 530.

In addition, the second connection member 22 is interposed between the bottom surface of the second back electrode substrate 120 and the top surface of the third window layer 530. The second back electrode substrate 120 is connected to the third window layer 530 through the second connection member 22. In other words, the second connection member 22 directly makes contact with the bottom surface of the second back electrode substrate 120 and the top surface of the third window layer 530.

The second connection member 22 may include a conductor, solder paste, or a conductive tape. Similarly to the first connection member 21, the second connection member 22 may include conductive polymer, and the second solar cell C2 and the third solar cell C3 are effectively connected to each other through the second connection member 22.

In addition, the bottom surface of the second back electrode substrate 120 may be connected to the top surface of the third window layer 530 through the direct contact with the top surface of the window layer 530.

As described above, the solar cells C1, C2, ..., and CN are connected to each other while being overlapped with each other, and are connected to each other in series.

Therefore, the solar cell apparatus according to the embodiment can be manufactured without a patterning process to distinguish between the solar cells C1, C2, ..., and CN, and to connect the solar cells C1, C,..., and CN to each other.

Therefore, the solar cell apparatus according to the embodiment can be easily manufactured.

In addition, in the solar cell apparatus according to the embodiment, the overlap region between the solar cells C1, C2,..., and CN can be minimized. In addition, the overlap region between the solar cells C1, C2, ..., and CN can convert the sun light into the electrical energy.

For example, a portion of the solar cell C1 overlapped with the second solar cell C2 can convert the sun light into the electrical energy.

Therefore, the solar cell apparatus according to the embodiment represents improved power generation efficiency.

In addition, the solar cell apparatus according to the embodiment may further include a protective substrate to cover the solar cells C1, C2,..., and CN. In this case, the protective substrate may be transparent, include an insulator, and be flexible. For example, the protective substrate may include an ethylene-vinyl acetate film.

In addition, the solar cells C1, C2, ..., and CN and the support substrate 10 may be flexible. Therefore, the solar cell apparatus according to the embodiment may be flexible over all.

FIGS. 5 to 8 are sectional views showing a method for manufacturing the solar cells. The above description about the solar cell apparatus will be incorporated in the description about the method for manufacturing according to the present embodiment.

Referring to FIG. 5, the back electrode substrate 100 including the group I element is prepared.

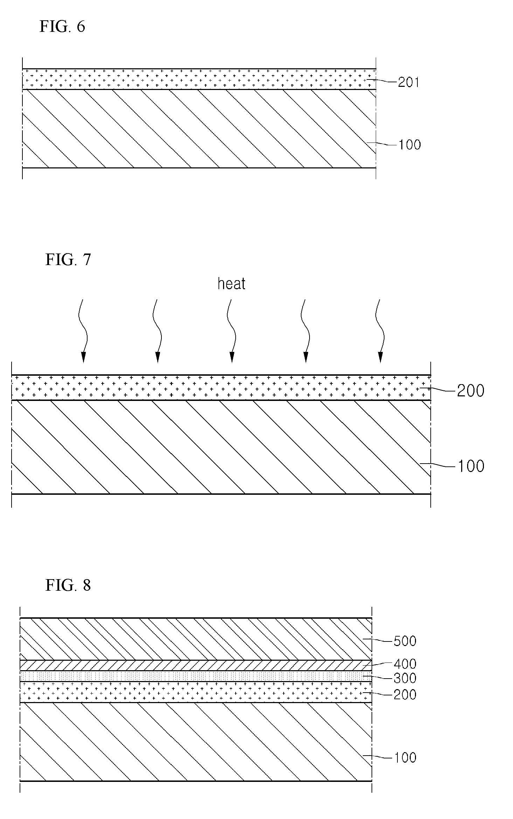

Referring to FIG. 6, a preliminary light absorbing layer 201 is formed on the back electrode substrate 100.

The preliminary light absorbing layer 201 may include a group III element or a group VI element. In more detail, the preliminary light absorbing layer 201 may include only a group III element. In more detail, the preliminary light absorbing layer 201 may include group III elements and group VI elements.

In addition, the preliminary light absorbing layer 201 may include one layer or a plurality of layers. In addition, a thickness of the preliminary light absorbing layer may be in the range of about 100nm to about 1000nm.

For example, the preliminary light absorbing layer 201 may include a single layer including a group III-VI-based compound. In detail, the preliminary light absorbing layer 201 may include an In-Se-based compound, an In-Ga-Se-based compound, a Ga-Se-based compound, an In-S-based compound, an In-Ga-S-based compound, a Ga-S-based compound, or an In-Ga-Se-S-based compound.

The group III-VI-based compound may be deposited through a sputtering process. In other words, the preliminary light absorbing layer 201 may be formed through a sputtering process using a sputtering target including the group III-VI-based compound.

The preliminary light absorbing layer 201 may be formed through a co-evaporation scheme to deposit a group III element and a group VI element while simultaneously evaporating the group III element and the group VI element.

In addition, the preliminary light absorbing layer 201 may be formed by printing a paste including the group III-VI-based compound on the back electrode substrate 100.

The preliminary light absorbing layer 201 may be formed by spraying a solution including the group III-VI-based compound on the back electrode substrate 100.

In addition, the preliminary light absorbing layer 201 may include only the group III element without the group VI element.

Referring to FIG. 7, after the preliminary light absorbing layer 201 has been formed, heat treatment is performed for both of the back electrode substrate 100 and the preliminary light absorbing layer 201.

Therefore, the group I element constituting the back electrode substrate 100 is spread into the preliminary light absorbing layer 201, and the group III-VI elements constituting the preliminary light absorbing layer 201 are spread into a portion of the back electrode substrate 100.

In addition, the group I element constituting the back electrode substrate 100 reacts with the group III-VI-based compounds constituting the preliminary light absorbing layer 201, thereby forming a group I-III-VI-based compound.

Therefore, the light absorbing layer 200 including the group I-III-VI-based compound is formed on the back electrode substrate 100.

The heat treatment process is performed in the temperature of about 300°C to about 650°C for about 5 min to about 60 min.

Referring to FIG. 8, a cadmium sulfide is deposited on the light absorbing layer 200 to form the buffer layer 300. Thereafter, a zinc oxide is deposited on the buffer layer 300 to form the high resistance buffer layer 400.

Thereafter, Al doped ZnO is deposited on the high resistance buffer layer 400 to form the window layer 500.

According to the method for manufacturing the solar cell of the embodiment, a process of depositing a group I element such as Ag or Cu is not required to form the light absorbing layer 200.

Therefore, the light absorbing layer 200 may be formed at a low temperature, and the solar cells C1, C2, ..., and CN can be easily manufactured.

The connection members 21, 22,..., and N are provided on one outer portion of the top surface of the solar cells C1, C2, ..., and CN, and the solar cells C1, C2, ..., and CN are connected to each other to be overlapped with each other. Thereafter, the protective substrate and the support substrate 10 are bonded with the top and bottom surfaces of the solar cells C1, C2, ..., and CN, respectively, thereby manufacturing the solar cell apparatus according to the embodiment.

As described above, the solar cell apparatus according to the embodiment can be manufactured without the patterning process.

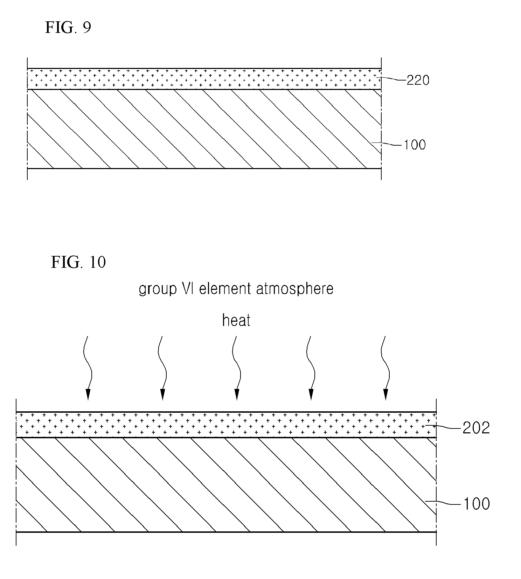

FIGS. 9 and 10 are sectional views showing a light absorbing layer according to another embodiment. The present embodiment will be described by making reference to the description about the previous embodiment. Procedures of forming a preliminary light absorbing layer and a light absorbing layer will be additionally described. The description about the previous embodiment will be incorporated in the description about the present embodiment except for the description about modifications.

Referring to FIG. 9, a preliminary light absorbing layer 202 is formed on the back electrode substrate 100. The preliminary light absorbing layer 202 includes a group III element. In detail, the preliminary light absorbing layer 2 includes a group III element or a group III element compound.

In this case, the preliminary light absorbing layer 202 does not include a group VI element.

For example, the preliminary light absorbing layer 202 may include In and/or Ga, or may include an Indium oxide or a Gallium oxide. In addition, the preliminary light absorbing layer 202 may include an Indium oxide layer or a gallium oxide layer.

Referring to FIG. 10, the preliminary light absorbing layer 202 and the back electrode substrate 100 are subject to heat treatment at the atmosphere of the group VI element such as Se, so that the light absorbing layer 200 is formed on the back electrode substrate 100. The group I element constituting the back electrode substrate 100, the group III element constituting the preliminary light absorbing layer 201, and the group VI element around the preliminary light absorbing layer 202 react each other, so that the group I-III-VI compound is formed, thereby forming the light absorbing layer 200.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### [Industrial Applicability]

The embodiment is applicable to a solar power generation field.

## Claims

1. A solar cell apparatus comprising:
a first solar cell; and
a second solar cell partially overlapping with the first solar cell and connected to the first solar cell.

2. The solar cell apparatus of claim 1, wherein the first solar cell comprises:
a first conductive substrate;
a first light absorbing layer on the first conductive substrate; and
a first window layer on the first light absorbing layer,
wherein the second solar cell comprises:
a second conductive substrate;
a second light absorbing layer on the second conductive substrate; and
a second window layer on the second light absorbing layer, and
wherein a bottom surface of the first conductive substrate makes contact with a top surface of the second window layer.

3. The solar cell apparatus of claim 2, wherein the first conductive substrate includes a group I element, and the first light absorbing layer includes the group I element, a group III element, and a group VI element.

4. The solar cell apparatus of claim 3, wherein a composition of the group I element in the first light absorbing layer is gradually increased in a direction toward the first conductive substrate.

5. The solar cell apparatus of claim 3, wherein the group I element includes silver (Ag) or copper (Cu).

6. The solar cell apparatus of claim 1, further comprising a connection member interposed between the first and second solar cells to connect the first solar cell to the second solar cell.

7. The solar cell apparatus of claim 6, wherein the connection member includes conductive polymer.

8. The solar cell apparatus of claim 6, wherein a width of the first solar cell is in a range of about 0.8cm to about 1.2cm, and a width of the connection member is in a range of about 20µm to about 500µm.

9. The solar cell apparatus of claim 1, further comprising a support substrate attached to lower portions of the first and second solar cells.

10. The solar cell apparatus of claim 9, wherein the support substrate is flexible.

11. A solar cell apparatus comprising:
an insulating substrate;
a first solar cell on the insulating substrate; and
a second solar cell having a portion interposed between the insulating substrate and the first solar cell while being connected to a bottom surface of the first solar cell.

12. The solar cell apparatus of claim 11, further comprising a connection member interposed between the bottom surface of the first solar cell and a top surface of the second solar cell while directly making contact with the bottom surface of the first solar cell and the top surface of the second solar cell.

13. The solar cell apparatus of claim 11, further comprising a protective substrate to cover the first and second solar cells.

14. The solar cell apparatus of claim 13, wherein the insulating substrate, the first solar cell, the second solar cell, and the protective substrate are flexible.

15. A solar cell apparatus comprising:
a first solar cell;
a second solar cell connected to the first solar cell; and
a connection member connecting the first solar cell to the second solar cell,
wherein the connection member includes conductive polymer.

16. The solar cell apparatus of claim 15, wherein the first solar cell includes a conductive substrate including a group I element, the second solar cell includes a window layer including a transparent conductive oxide, and the connection member directly makes contact with the conductive substrate and the window layer.

17. The solar cell apparatus of claim 16, wherein the conductive substrate includes copper (Cu) or silver (Ag), and the window layer includes a zinc oxide.

18. The solar cell
apparatus of claim 15, wherein the first and second solar cells are overlapped with each other, and the connection member directly makes contact with a bottom surface of the first solar cell and a top surface of the second solar cell.

19. The solar cell apparatus of claim 15, wherein the conductive polymer includes anthracene conductive polymer, polyaniline conductive polymer, or poly(ethylenedioxythiophene):poly(styrene sulfonate) (PEDOT:PSS)-based conductive polymer.

20. The solar cell apparatus of claim 15, wherein the connection member has elasticity.
